# EUROPÄISCHE PATENTSCHRIFT

(11) **EP 3 498 879 B1**
(45) Veröffentlichungstag und Bekanntmachung des Hinweises auf die Patenterteilung: **04.05.2022**
(21) Anmeldenummer: 17207106.0
(22) Anmeldetag: 13.12.2017
(51) Int. Cl.: C23C 14/00, C23C 14/20, B05D 5/06, B05D 7/00

(54) **VERFAHREN ZUR HERSTELLUNG BESCHICHTETER SUBSTRATE, BESCHICHTETE SUBSTRATE UND DEREN VERWENDUNG**
COATED SUBSTRATES AND METHOD FOR THE PRODUCTION OF COATED SUBSTRATES AND THEIR USE
PROCÉDÉ DE FABRICATION DE SUBSTRAT REVÊTU, SUBSTRAT REVÊTU ET SON UTILISATION

(43) Veröffentlichungstag der Anmeldung: 19.06.2019
(73) Patentinhaber: HEC High End Coating GmbH, 35108 Allendorf (Eder) (DE)
(72) Erfinder: KOCH, Matthias, 59969 Bromskirchen (DE)
(74) Vertreter: Metten, Karl-Heinz

(56) Entgegenhaltungen:
- EP-A1- 3 225 717

## Beschreibung

Die vorliegende Erfindung betrifft ein Verfahren zur Herstellung beschichteter Substrate sowie beschichtete Substrate und die Verwendung dieser beschichteten Substrate.

Metallische wie nicht-metallische Bauteile werden häufig zur Erzeugung einer glatten und/oder glänzenden Oberfläche beschichtet. In der Regel handelt es sich hierbei um mehrlagige Beschichtungssysteme. Neben dem Wunsch, eine Oberfläche mit hochwertiger Anmutung zu erhalten, wird mit derartigen Beschichtungssystemen regelmäßig auch ein ausgeprägter Korrosionsschutz angestrebt. Ein dauerhafter Korrosionsschutz wird nicht selten durch mechanische Beschädigung zunichte gemacht. Vielfach setzt bereits bei geringfügigen mechanischen Beschädigungen beschichteter Oberflächen Korrosion ein. Dies kann neben Verfärbungen auch Unterwanderungsphänomene zur Folge haben. Nicht selten führt dies dann zum Abplatzen von Beschichtungsarealen. Es hat nicht an Versuchen gefehlt, beschichtete glänzende Oberflächen korrosionsbeständig auszustatten. Beispielsweise beschreibt die DE 123 765 A1 ein Verfahren zur Erzeugung einer Korrosionsschutzschicht auf einer metallischen Oberfläche, bei dem ein auf Siliziumverbindungen basierendes Sol, ein Aminoalkyl-funktionalisiertes Alkoxysilan oder ein Umsetzungsprodukt der beiden vorangehend genannten Komponenten zum Einsatz kommt.

Gemäß der DE 38 33 119 C2 erhält man eine sehr gut auf einem Substrat haftende korrosionsgeschützte chromatierte Metalloberfläche dadurch, dass ein Elektrotauchlack direkt auf die Chromatierschicht ohne Zwischentrocknung abgeschieden wird.

Vielfach versucht man das Problem des Korrosionsschutzes bzw. der Erzeugung von glatten beschichteten Oberflächen dadurch zu lösen, dass man für einzelne Schichten oder sogleich für mehrere Schichten eines Beschichtungssystem den Materialauftrag, d.h. die Schichtdicke erhöht. Hierdurch steigen nicht nur die eingesetzte Menge, der Arbeitsaufwand und die Kosten, auch kommt es häufig zu einem ungewünschten Materialauftrag im Rand- bzw. Kantenbereich von Bauteilen.

Korrosionsschutzbeschichtungen insbesondere für Metallsubstrate zeigen noch stets erhebliches Verbesserungspotential in Sachen Haftung und Korrosionsschutz, insbesondere bei massengefertigten Produkten, vor allem solchen mit anspruchsvoller Geometrie.

Auch ist es vielfach nicht trivial, hochwertig anmutende Substratoberflächen auf einfache und kostengünstige Weise in der Massenfertigung reproduzierbar herzustellen. Derartige Oberflächen bedürfen zumeist des Einsatzes der Galvanotechnik. Um sogenannte schwarz verchromte Beschichtungen zu erhalten, welche häufig eine besonders edle Anmutung liefern, ist der Aufwand noch einmal zu erhöhen. Denn hierfür benötigt man eine erhöhte Stromdichte in Verbindung mit speziellen Zusätzen. Weiterer relevanter Stand der Technik ist in der Druckschrift EP3225717 A1 offenbart.

Der vorliegenden Erfindung lag daher die Aufgabe zu Grunde, beschichtete Substrate zur Verfügung zu stellen, die nicht mehr mit den Nachteilen des Stands der Technik behaftetet sind und die insbesondere auch in der Massenfertigung beschichtete Produkte mit verbessertem Korrosionsschutz und/oder sehr guten Haftungseigenschaften und/oder hochwertigen Oberflächeneigenschaften liefern. Es werden dabei auch solche beschichteten Produkte angestrebt, die bei mechanischer Oberflächenbeschädigung nicht sogleich Unterwanderungsphänomene zeigen, insbesondere auch nicht verbunden mit dem Abblättern von Schichten. Des Weiteren lag der Erfindung die Aufgabe zugrunde, zu beschichteten Substraten zu gelangen, die selbst mit komplexer Geometrie über das gesamte Bauteil, einschließlich im Bereich von Kantenverläufen, ein gleichwertig hohes Beschichtungsergebnis zeigen.

Demgemäß wurde ein Verfahren zur Herstellung eines beschichteten metallischen Substrats oder eines beschichteten nicht-metallischen Substrats, insbesondere Kunststoffsubstrats, umfassend
a) Zurverfügungstellung eines metallischen Substrats oder eines nicht-metallischen Substrats, insbesondere Kunststoffsubstrats, mit mindestens einer zumindest bereichsweise beschichtbaren Oberfläche,
b) Zurverfügungstellung einer Applikationsanlage für die Aufbringung einer Metallschicht, insbesondere Vakuumaufdampfanlage oder Sputter-Anlage, und Zurverfügungstellung mindestens eines Plasmagenerators und/oder mindestens einer Corona-Anlage, insbesondere in der Applikationsanlage für die Aufbringung einer Metallschicht, wie Vakuumaufdampfanlage oder Sputter-Anlage, oder als Bestandteil hiervon,
c) gegebenenfalls Reinigen der mindestens einen zumindest bereichsweise beschichtbaren Oberfläche,
d) Beaufschlagen des metallischen Substrats oder des nicht-metallischen Substrats, insbesondere Kunststoffsubstrats, oder der beschichtbaren Oberfläche des metallischen Substrats oder des nicht-metallischen Substrats, insbesondere Kunststoffsubstrats, mit einem Vakuum (d1)) und Plasmabehandlung mit dem Plasmagenerator des metallischen Substrats oder des nicht-metallischen Substrats, insbesondere Kunststoffsubstrats, oder der beschichtbaren Oberfläche des nicht-metallischen Substrats, insbesondere Kunststoffsubstrats, oder des metallischen Substrats, im Vakuum (d2)),
e) Behandeln des nach Schritt d) erhaltenen metallischen Substrats oder nicht-metallischen Substrats, insbesondere Kunststoffsubstrats, oder der nach Schritt d) erhaltenen beschichtbaren Oberfläche des metallischen Substrats oder des nicht-metallischen Substrats, insbesondere Kunststoffsubstrats, mit mindestens einer siliziumorganischen Verbindung mittels Plasmapolymerisation, insbesondere unter Ausbildung einer Polysiloxanschicht,
f) gegebenenfalls Plasmabehandlung, vorzugsweise im Vakuum, mit dem Plasmagenerator und/oder Corona-Behandlung, insbesondere Plasmabehandlung, der Schicht, insbesondere Polysiloxanschicht, gemäß Schritt e),
g) Aufbringen mindestens einer Grundierungsschicht auf das metallische Substrat oder das nicht-metallische Substrat, insbesondere Kunststoffsubstrat, oder die beschichtbare Oberfläche des metallischen Substrats oder des nicht-metallischen Substrats, insbesondere Kunststoffsubstrats, gemäß Schritt e) oder f),
h) Beaufschlagen des mit der Grundierungsschicht versehenen metallischen Substrats oder des mit der Grundierungsschicht versehenen nicht-metallischen Substrats, insbesondere Kunststoffsubstrats mit einem Vakuum (h1)) und Plasmabehandlung mit dem Plasmagenerator der Grundierungsschicht gemäß Schritt g) im Vakuum (h2)),
i) gegebenenfalls Behandeln der nach Schritt g) oder h), insbesondere h1) und h2), erhaltenen Grundierungsschicht mit mindestens einer siliziumorganischen Verbindung, insbesondere mittels Plasmapolymerisation, insbesondere unter Ausbildung einer Polysiloxanschicht, insbesondere im Vakuum,
j) gegebenenfalls Plasmabehandlung mit dem Plasmagenerator und/oder Corona-Behandlung, insbesondere Plasmabehandlung, der Schicht, insbesondere Polysiloxanschicht, gemäß Schritt i), insbesondere im Vakuum,
k) Aufbringen mindestens einer Metallschicht, enthaltend oder bestehend aus einem Metall ausgewählt aus der Gruppe bestehend aus Aluminium, Silber, Gold, Blei, Vanadium, Mangan, Magnesium, Eisen, Kobalt, Nickel, Kupfer, Chrom, Palladium, Molybdän, Wolfram, Platin, Titan, Zirkonium und Zink, insbesondere Aluminium, oder enthaltend oder bestehend aus einer Metalllegierung ausgewählt aus der Gruppe bestehend aus Messing, Bronze, Stahl, insbesondere Edelstahl, Aluminium-, Magnesium- und Titanlegierungen, mit der Applikationsanlage mittels Aufdampf- und/oder Sputter-Technik unmittelbar auf die behandelte Grundierungsschicht gemäß Schritt h2), oder i) oder j),
l) gegebenenfalls Plasmabehandlung mit dem Plasmagenerator und/oder Corona-Behandlung, insbesondere Plasmabehandlung, der Metallschicht gemäß Schritt k),
m) Behandeln der nach Schritt k) oder l) erhaltenen Metallschicht mit mindestens einer siliziumorganischen Verbindung mittels Plasmapolymerisation, insbesondere unter Ausbildung einer Polysiloxanschicht im Vakuum,
n) Plasmabehandlung mit dem Plasmagenerator der Schicht, insbesondere Polysiloxanschicht, gemäß Schritt m) im Vakuum, und
o) Auftragen mindestens einer, insbesondere transparenten und/oder eingefärbten, Deckschicht auf die behandelte Schicht, insbesondere Polysiloxanschicht, gemäß Schritt n).

In einer praktikablen Ausgestaltung des erfindungsgemäßen Verfahrens umfasst dieses zusätzlich zu den Schritten a) und b) gegebenenfalls c) die Abfolge der Schritte d1), d2), g), h1), h2), k), m), n) und o), wobei diese, vorzugsweise unmittelbar, aufeinander folgen.

Ferner umfasst das erfindungsgemäße Verfahren solche geeigneten Ausführungsformen, in denen die Schritte g), h), insbesondere h1) und h2), k), m), n) und o), oder die Schritte g), h1) und h2), j), k), l), m), n) und o), oder die Schritte d1) und d2), g), h1) und h2), k), m), n) und o), oder die Schritte d1) und d2), e), f), g), h1) und h2), k), m), n) und o), insbesondere unter Auslassung der Schritte i) und j), jeweils, insbesondere unmittelbar, aufeinander folgen.

Hierbei kann in einer geeigneten Ausführungsform vor dem Schritt der Aufbringung der Metallschicht k) auch die Aufbringung einer, insbesondere plasmagenerierten, Polysiloxanschicht vorgesehen werden.

Eine Behandlung bzw. ein Auftrag/eine Beschichtung auf "d1) und d2)" im Sinne der Erfindung soll bedeuten, dass der Auftrag/Behandlung/Beschichtung nach Schritt d2) folgt und dass der Schritt d1) dem Schritt d2) vorgeschaltet ist. Die Kombination der Merkmale d1) und d2) ist hierbei als Einheit zu betrachten. Demgemäß ist hiermit nicht gemeint, dass der Auftrag/Beschichtung bzw. Behandlung sowohl nach Schritt d1) als auch nach Schritt d2) stattzufinden hat. Entsprechendes gilt für das Merkmal "h1) und h2)".

In einer besonders zweckmäßigen Ausgestaltung, insbesondere wie vorangehend spezifiziert, wird die Schicht, auf die die Metallschicht gemäß Schritt k) aufgebracht wird, vor dem Schritt k) im Vakuum einer Plasmabehandlung mit dem Plasmagenerator unterzogen.

Die der Erfindung zu Grunde liegende Aufgabe wird dabei insbesondere auch durch ein solches Verfahren gelöst, umfassend die Schritte
a) Zurverfügungstellung eines metallischen Substrats oder eines nicht-metallischen Substrats, insbesondere Kunststoffsubstrats, mit mindestens einer zumindest bereichsweise beschichtbaren Oberfläche,
b) Zurverfügungstellung einer Applikationsanlage für die Aufbringung einer Metallschicht, nämlich Vakuumaufdampfanlage oder Sputter-Anlage und Zurverfü- gungstellung mindestens eines Plasmagenerators, insbesondere in der Vakuumaufdampfanlage oder Sputter-Anlage, oder als Bestandteil hiervon,
c) gegebenenfalls Reinigen der mindestens einen zumindest bereichsweise beschichtbaren Oberfläche,
d) Beaufschlagen des metallischen Substrats oder des nicht-metallischen Substrats, insbesondere Kunststoffsubstrats, oder der beschichtbaren Oberfläche des metallischen Substrats oder des nicht-metallischen Substrats, insbesondere Kunststoffsubstrats, mit einem Vakuum (d1)) und Plasmabehandlung mit dem Plasmagenerator des metallischen Substrats oder des nicht-metallischen Substrats, insbesondere Kunststoffsubstrats, oder der beschichtbaren Oberfläche des metallischen oder des nicht-metallischen Substrats, insbesondere Kunststoffsubstrats, im Vakuum (d2)),
e) Behandeln des nach Schritt d) erhaltenen metallischen Substrats oder nicht-metallischen Substrats, insbesondere Kunststoffsubstrats, oder der beschichtbaren Oberfläche des metallischen Substrats oder des nicht-metallischen Substrats, insbesondere Kunststoffsubstrats, mit mindestens einer siliziumorganischen Verbindung mittels Plasmapolymerisation, insbesondere unter Ausbildung einer Polysiloxanschicht,
f) gegebenenfalls Plasmabehandlung mit dem Plasmagenerator der Schicht, insbesondere Polysiloxanschicht, gemäß Schritt e),
g) Aufbringen mindestens einer Grundierungsschicht auf das metallische Substrat oder das nicht-metallische Substrat, insbesondere Kunststoffsubstrat, oder die beschichtbare Oberfläche des metallischen Substrats oder des nicht-metallischen Substrats, insbesondere Kunststoffsubstrats, gemäß Schritt d) oder auf die Schicht, insbesondere Polysiloxanschicht, gemäß Schritt e) oder f) ,
h) Beaufschlagen des mit der Grundierungsschicht versehenen metallischen Substrats oder des mit der Grundierungsschicht versehenen nicht-metallischen Substrats, insbesondere Kunststoffsubstrats mit einem Vakuum (h1)) und Plasmabehandlung mit dem Plasmagenerator der Grundierungsschicht gemäß Schritt g) im Vakuum (h2)),
i) gegebenenfalls Behandeln der nach Schritt g) oder h), insbesondere h1) und h2), erhaltenen Grundierungsschicht mit mindestens einer siliziumorganischen Verbindung, insbesondere mittels Plasmapolymerisation, insbesondre unter Ausbildung einer Polysiloxanschicht, insbesondere im Vakuum,
j) gegebenenfalls Plasmabehandlung mit dem Plasmagenerator der Schicht, insbesondere Polysiloxanschicht, gemäß Schritt i), insbesondere im Vakuum,
k) Aufbringen mindestens einer Metallschicht, enthaltend oder bestehend aus Aluminium oder einer Aluminium-, Magnesium- oder Titanlegierung mit der Applikationsanlage mittels Aufdampf- und/oder Sputtertechnik unmittelbar auf die behandelte Grundierungsschicht gemäß Schritt h2), oder i) oder j),
l) gegebenenfalls Plasmabehandlung mit dem Plasmagenerator der Metallschicht gemäß Schritt k),
m) Behandeln der nach Schritt k) oder l) erhaltenen Metallschicht mit mindestens einer siliziumorganischen Verbindung mittels Plasmapolymerisation, insbesondere unter Ausbildung einer Polysiloxanschicht im Vakuum,
n) Plasmabehandlung mit dem Plasmagenerator der Schicht, insbesondere Polysiloxanschicht, gemäß Schritt m) im Vakuum, und
o) Auftragen mindestens einer, insbesondere transparenten und/oder eingefärbten, Deckschicht auf die behandelte Schicht, insbesondere Polysiloxanschicht, gemäß Schritt n).

Bei dieser Verfahrensvariante ist der Schritt f) nur optional. Er kann in Einzelfällen zu einer nochmals verbesserten Haftung und einem nochmals erhöhten Korrosionsschutz beitragen.

Es hat sich für einige Anwendungen des erfindungsgemäßen Verfahrens gezeigt, dass es von Vorteil ist, wenn beidseitig der Metallschicht eine, insbesondere plasmagenerierte, Polysiloxanschicht vorliegt, die vorzugsweise jeweils einer Plasmabehandlung unterzogen wurde.

Das erfindungsgemäße Verfahren umfasst in Schritt g) die Aufbringung einer Grundierungsschicht. Hierdurch lassen sich zum Beispiel Unebenheiten von zu beschichtenden Substraten mit minderer Qualität ausgleichen.

Es hat sich als vorteilhaft erwiesen, die vorangehend genannten Verfahrensschritte im Wesentlichen unmittelbar aufeinanderfolgen zu lassen. Dies bedeutet insbesondere, dass nach den Plasmabehandlungsschritten eine längere Lagerung vermieden werden sollte. Vielmehr ist es von Vorteil, wenn der nachfolgende Verfahrensschritt direkt folgt. Auch hat sich gezeigt, dass neben den vorangehend genannten Verfahrensschritten es nicht zwingend erforderlich ist, weitere Verfahrensschritte zwischenzuschalten.

Geeignete nicht-metallische Substrate umfassen Glas, Keramik, Steinmaterialien, Verbundfasermaterialien, Carbonmaterialien, Kunststoff oder Holz. Besonders gut geeignet ist das hier geschilderte erfindungsgemäße Verfahren für die Beschichtung von Kunststoffsubstraten zwecks Erhalts dauerhaft hochglänzender Produkte. Geeignete Kunststoffsubstrate umfassen oder bestehen z.B. aus PVC, Polyurethanen, Polyacrylaten, Polyestern, z.B. PBT und PET, Polyolefinen, insbesondere Polypropylen, Polycarbonaten, Polyamiden, Polyphenylenethern, Polystyrol, Styrol(co)polymere, wie ABS, z.B. Galvano-ABS, SAN, ASA oder MABS, Polyoxyalkylene, z.B. POM, Teflon und Polymerblends, insbesondere ABS/PPE-, ASA/PPE-, SAN/PPE- und/oder ABS/PC-Blends.

Für die Metallsubstrate kann auf Metalle und Metalllegierungen zurückgegriffen werden, wobei besonders geeignete Metallsubstrate ausgewählt werden können aus der Gruppe bestehend aus Aluminium, Aluminiumlegierungen, Eisen, Eisenlegierungen, insbesondere Stahl oder Edelstahl, Kupfer, Kupferlegierungen, Titan, Titanlegierungen, Zink, Zinklegierungen, Nickel, Nicklegierungen, Molybdän, Molybdänlegierungen, Magnesium, Magnesiumlegierungen, Blei, Bleilegierungen, Wolfram, Wolframlegierungen, Mangan, Manganlegierungen, Messing, Bronze, Nickeldruckguss, Zinkdruckguss und Aluminiumdruckguss oder deren beliebige Mischungen.

Geeignete Verfahren zur Reinigung von Metallsubstraten sind dem Fachmann bekannt. Derartige Reinigungsverfahren umfassen das Entfetten, Dekapieren, Phosphatieren, insbesondere Eisen- und/oder Zinkphosphatieren, Polieren, Schleifen, insbesondere Gleitschleifen, und/oder Behandeln mit Trockeneis. Diese Verfahren können sowohl einzeln als auch in beliebiger Kombination eingesetzt werden. Für viele Anwendungen hatte sich als ausreichend erwiesen, die Metallsubstrate durch Behandlung mit Trockeneis zu reinigen und/oder diese zu entfetten. Vielfach reicht das Entfetten bereits aus. Ohne an eine Theorie gebunden zu sein, wird gegenwärtig vermutet, dass mit den nachfolgenden Verfahrensschritten des erfindungsgemäßen Verfahrens eine hinreichende Versiegelung bzw. Veredelung der Substratoberfläche erfolgt. Bei der Reinigung mit Trockeneis werden im Allgemeinen Trockeneispartikeln in Form von Pellets oder in Form von Kristallen, die von einem entsprechenden Trockeneisblock abgeschabt worden sind, mit Hilfe von Druckluft beschleunigt und auf die zu reinigende Metalloberfläche geleitet. Der Reinigungseffekt soll hierbei auf thermische, kinetische und Phasenumwandlungseffekte zurückzuführen sein. Vorrichtungen und Verfahren zur Reinigung von Metalloberflächen mit Trockeneis sind zum Beispiel der DE 195 44 906 A1 und EP 2 886 250 zu entnehmen.

Die Oberfläche von Metallsubstrate kann beispielsweise mit alkalischen oder sauren Reagenzien entfettet werden. Kommerzielle Entfettungsschritte sind auch unter den Begriffen Abkoch- bzw. Beizentfetten bekannt. Alternativ kann eine Metalloberfläche in einem elektrolytischen Entfettungsbad anodisch entfettet werden.

Für manche Ausführungsvarianten ist es vorteilhaft, die, insbesondere entfettete, Metallsubstratoberfläche mindestens einem Dekapierschritt zu unterziehen. Für die Dekapierung der Metallsubstratoberfläche setzt man z.B. ein saures Spülbad ein. Eine geeignete Dekapierlösung stellt demgemäß z.B. verdünnte Salzsäure (1:10 vol/vol) dar. Im Ergebnis erhält man mittels Dekapierung in der Regel eine im Wesentlichen oxidfreie Metalloberfläche. Ebenso wie der Entfettungsschritt wird auch der Dekapierschritt im Allgemeinen durch einen Spülschritt abgeschlossen. Wird die Metallsubstratoberfläche poliert und/oder geschliffen bzw. insbesondere gleitgeschliffen, kann häufig der Entfettungs- und/oder Dekapierschritt entfallen. Üblicherweise wird bei dieser Art der Oberflächenbearbeitung hinreichend Material von dieser Oberfläche abgetragen, womit dann auch auf der Oberfläche aufliegende bzw. anhaftende Verunreinigungen oder anderweitige Bestandteile mit entfernt werden.

Anschließend an oder anstelle des Entfettungsschritts kann die metallische Substratoberfläche phosphatiert und/oder zu passiviert werden. Dies ist insbesondere bei Substraten aus oder enthaltend Aluminium eine geeignete Vorgehensweise.

Zur Aufbringung einer Grundierungsschicht gemäß dem erfindungsgemäßen Verfahren stehen dem Fachmann allseits bekannte Verfahren zur Verfügung. Exemplarisch seien das Nasslackverfahren, das Pulverbeschichtungsverfahren oder die Auftragung mittels UVhärtender Beschichtungssysteme genannt. Demgemäß kann die Grundierungsschicht in einer bevorzugten Ausgestaltung auf, insbesondere UV-härtende, pulverförmige Polyesterharzverbindungen oder auf Epoxid/Polyester-Pulver zurückgehen. Dies Ergebnis ist insoweit überraschend, als UV-härtende Beschichtungen, beispielsweise Grundierungsbeschichtungen, regelmäßig zu sehr harten Schichten aushärten und für eine weitere Manipulation schwierig zugänglich sind und/oder zur Rissbildung neigen. Selbstverständlich ist es auch möglich, vor der Aufbringung einer Grundierungsschicht, wie vorangehend beschrieben, eine mechanische Glättung der Metallsubstratoberfläche, beispielsweise mittels Schleifens und/oder Polierens bzw. Gleitschleifens, durchzuführen. Des Weiteren kann die Grundierungsschicht auch mittels elektrostatischer Lackierung aufgetragen werden kann.

Geeignete siliziumorganische Verbindungen sind dem Fachmann bekannt. In einer zweckmäßigen Ausgestaltung wird hierfür zurückgegriffen auf mindestens ein aminohaltiges Silan, insbesondere Aminopropyltriethoxysilan, Hexamethyldisiloxan, Tetramethyldisiloxan oder deren beliebige Mischungen. Besonders bevorzugt kommen Hexamethyldisiloxan und Tetramethyldisiloxan zum Einsatz, wobei Hexamethyldisiloxan regelmäßig besonders geeignet ist.

Geeignete siliziumorganische Verbindungen umfassen ebenfalls, als Monomer- oder als Comonomer-Bausteine, Verbindungen der folgenden Formel (I):

X-R₁-Si(R₂)₃₋ₘ(R₃)ₘ (I),

wobei die Substituenten und Indizes die folgende Bedeutung haben:
- m: 0, 1, 2 oder 3, insbesondere 2 oder 3,
- R1: C1- bis C10-Kohlenwasserstoffrest, insbesondere eine C1- bis C10-Kohlenwasserstoffkette, die durch Sauerstoff oder Stickstoff unterbrochen sein kann, insbesondere Methyl, Ethyl oder i- oder n-Propyl, vorzugsweise i- oder n-Propyl,
- R2: gleiche oder verschiedene hydrolysierbare Gruppen, insbesondere Alkoxygruppen wie Methoxy-, Ethoxy-, n-Propoxy, i-Propoxy, n-Butoxy, i-Butoxy oder t-Butoxy, insbesondere Methoxy oder Ethoxy,
- R3: gleiche oder verschiedene C1- bis C5-Alkylgruppen, insbesondere Methyl, Ethyl oder i- oder n-Propyl, vorzugsweise i- oder n-Propyl,
- X: funktionelle polymerisierbare Gruppe, insbesondere ein in ω-Stellung ungesättigter organischer Rest wie eine in ω-Stellung ungesättigte Alkenylgruppe mit 1 bis 10, vorzugsweise 2 bis 4 C-Atomen oder ein in ω-Stellung ungesättigter Carbonsäureesterrest von Carbonsäuren mit bis zu 4 Kohlenstoffatomen und Alkoholen mit bis zu 6 Kohlenstoffatomen.

Besonders geeignete Reste X umfassen z.B. Vinyl, Alkylvinyl, insbesondere Methyl-, Ethyl-oder Propylvinyl, (Meth)acryloxyalkyl, insbesondere (Meth)acryloxymethyl, (Meth)acryloxyethylen oder (Meth)acryloxypropyl, insbesondere (Meth)acryloxypropyl.

In einer zweckmäßigen Ausführungsform des erfindungsgemäßen Verfahrens ist vorgesehen, dass die siliziumorganische Verbindung über eine Zuführleitung aus einem außerhalb der Applikationsanlage für die Aufbringung einer Metallschicht, insbesondere außerhalb der Vakuumkammer der Vakuumaufdampfanlage, befindlichen Behältnis dieser Applikationsanlage, insbesondere Vakuumkammer, zugeführt wird. Auch ist es möglich, dass der siliziumorganischen Verbindung ein Farbmittel, insbesondere Farbstoff, zugesetzt ist. Demgemäß zeichnen sich die erfindungsgemäßen Verfahren in einer zweckmäßigen Ausgestaltung auch dadurch aus, dass man gemeinsam mit der mindestens einen siliziumorganischen Verbindung, insbesondere für die Plasmapolymerisation, mindestens ein Farbmittel, insbesondere einen Farbstoff, in die Applikationsanlage für die Aufbringung einer Metallschicht, vorzugsweise in Form eines Gemisches, einbringt.

Für die Durchführung des erfindungsgemäßen Verfahrens kann demgemäß auf eine Applikationsanlage für die Aufbringung einer Metallschicht zurückgegriffen werden, umfassend mindestens ein insbesondere außerhalb der Applikationsanlage für die Aufbringung einer Metallschicht, insbesondere außerhalb der Vakuumkammer der Vakuumaufdampfanlage, vorliegendes Behältnis zur Aufnahme einer siliziumorganischen Verbindung mit einer Zuführleitung zu der Applikationsanlage, insbesondere zur Vakuumkammer.

Eine gute Haftung ohne Einschränkungen bei der Korrosionsbeständigkeit kann man insbesondere auch dadurch erhalten, dass der Schritt der Behandlung mit mindestens einer siliziumorganischen Verbindung wie Hexamethyldisiloxan, insbesondere mittels Plasmapolymerisation, unter Ausbildung einer Polysiloxanschicht in Gegenwart mindestens eines reaktiven Gases wie Sauerstoff, Stickstoff, Kohlendioxid, Wasserstoff, Kohlenmonoxid, Wasserstoffperoxidgas, Wasserdampf, Ozon und/oder Luft, insbesondere in Gegenwart von Sauerstoff oder Luft, durchgeführt wird. Über die Einbindung von reaktiven Gasen, insbesondere Luft oder Sauerstoff, in den, insbesondere plasmagenerierten, Polymerisationsprozess erhält man härtere Polysiloxanschichten als bei der herkömmlichen Herstellung solcher Polysiloxanschichten ohne Mitverwendung der geschilderten reaktiven Gas. Diese härteren Polysiloxanschichten zeichnen sich auch durch eine größere Diffusionsgeschlossenheit aus. Hierbei kann in einer besonders zweckmäßigen Ausführungsform vorgesehen sein, dass die mindestens eine siliziumorganische Verbindung, insbesondere Hexamethyldisiloxan, und das mindestens eine reaktive Gas, insbesondere Sauerstoff oder Luft, als Mischung für den Behandlungsschritt eingesetzt werden. Die vorangehend geschilderte Ausführungsform der Mitverwendung reaktive Gase bei der, insbesondere plasmagenerierten, Herstellung der Polysiloxanschicht kommt vorzugsweise bei mindestens einem Schritt der Behandlung mit mindestens einer siliziumorganischen Verbindung, insbesondere mittels Plasmapolymerisation, unter Ausbildung einer Polysiloxanschicht oder aber auch bei jedem Schritt zur Herstellung einer Polysiloxanschicht zum Einsatz. Besonders bevorzugt wird diese Verfahrensvariante bei der Herstellung beschichteter metallischer Substrate und bei der Herstellung beschichteter nicht-metallischer Substrate, insbesondere von Kunststoffsubstraten, in Verfahrensschritt m) eingesetzt. In dem dem genannten Verfahrensschritt m) folgenden Verfahrensschritt n) wird die Plasmabehandlung bevorzugt mit Hilfe eines Plasmagases gebildet aus einem Inertgas, insbesondere Sauerstoff, und in dem Verfahrensschritt d) wird die Plasmabehandlung bevorzugt mit Hilfe eines Plasmagases enthaltend Argaon durchgeführt. Auch diese Vorgehensweise trägt nochmals zu einer verbesserten Haftung des Gesamtsystems bei.

Für den Schritt der Plasmabehandlung mit dem Plasmagenerator stehen grundsätzlich mehrere Verfahrensvarianten zur Auswahl. Gemäß einer ersten Variante kann das Plasma unter Einsatz mindestens eines Inertgases, insbesondere Argon, gebildet werden. Alternativ kann für die Generierung eines geeigneten Plasmas auch auf Mischungen aus mindestens einem Inertgas, insbesondere Argon, und einem reaktiven Gas wie Sauerstoff, Stickstoff, Kohlendioxid, Wasserstoff, Kohlenmonoxid, Wasserstoffperoxidgas, Wasserdampf, Ozon und/oder Luft zurückgegriffen werden. Bevorzugt kommen hierbei Sauerstoff und Stickstoff, insbesondere Sauerstoff, zum Einsatz. Schließlich ist es auch möglich, unter Verzicht von Inertgasen ausschließlich reaktive Gase wie Sauerstoff, Stickstoff, Wasserstoff, Kohlendioxid, Kohlenmonoxid, Wasserstoffperoxidgas, Wasserdampf, Ozon und/oder Luft für die Erzeugung des Plasmas einzusetzen. Hierbei wird bevorzugt auf Sauerstoff zurückgegriffen. Mit Hilfe einer Plasmabehandlung mit dem Plasmagenerator wird die zu beschichtende Oberfläche des Substrats aktiviert. Bei einem Plasmaverfahren wirkt regelmäßig ein energiereiches Plasma auf die Oberfläche des Formteils ein, so dass auf dieser Oberfläche aktive Zentren gebildet werden. Hierbei kann es sich beispielsweise um Hydroxygruppen und/oder um Carbonyl-Gruppen handeln.

Demgemäß kann in einer besonders geeigneten Ausgestaltung des erfindungsgemäßen Verfahrens vorgesehen sein, dass der Schritt der Plasmabehandlung mit dem Plasmagenerator unter Einsatz von mindestens einem Inertgas, insbesondere Argon, oder unter Einsatz von mindestens einem Inertgas, insbesondere Argon, und Sauerstoff, Stickstoff, Kohlendioxid, Wasserstoff, Kohlenmonoxid, Wasserstoffperoxidgas, Wasserdampf, Ozon und/oder Luft, insbesondere Sauerstoff, oder unter Einsatz von Sauerstoff, Stickstoff, Wasserstoff, Kohlendioxid, Kohlenmonoxid, Wasserstoffperoxidgas, Wasserdampf, Ozon und/oder Luft, insbesondere Sauerstoff, vorzugsweise unter Ausschluss von Inertgasen, durchgeführt wird. Dabei sind solche Verfahrensvarianten besonders bevorzugt, bei denen die, insbesondere jede, Plasmabehandlung mit dem Plasmagenerator und/oder die, insbesondere jede, Aufbringung der Metallschicht und/oder die, insbesondere jede, Aufbringung der durch Plasmabehandlung von siliziumorganischen Verbindungen erhaltenen Schicht, insbesondere Polysiloxanschicht, in der Vakuumaufdampfanlage oder in der Sputter-Anlage, vorgenommen wird.

Die der Erfindung zu Grunde liegende Aufgabe wird besonders gut gelöst durch solche erfindungsgemäßen Verfahren, bei denen die Plasmabehandlung gemäß Schritt d2) und/oder f), insbesondere d2), unter Einsatz von Argon, in einer zweckmäßigen Ausgestaltung unter Ausschluss von Luft oder Sauerstoff, und/oder dass die Plasmabehandlung gemäß Schritt h2) und/oder j), insbesondere j), unter Einsatz von Sauerstoff, in einer zweckmäßigen Ausgestaltung unter Ausschluss von Inertgasen wie Argon, durchgeführt wird.

Das erfindungsgemäße Verfahren bietet den großen Vorteil, dass nahezu sämtliche Verfahrensschritte in der Applikationsanlage für die Aufbringung einer Metallschicht durchgeführt werden können. Dies betrifft neben der Aufbringung der weiten Metallschicht auch die Aktivierung von Oberflächen mittels der Plasmabehandlung mit dem Plasmagenerator ebenso wie die Aufbringung der Schicht gebildet aus siliziumorganischen Verbindungen, insbesondere der Polysiloxanschicht, insbesondere mittels Plasmapolymerisation. Einzig die Reinigungsschritte, die Aufbringung der Grundierungsschicht und die Aufbringung der Deckschicht werden regelmäßig außerhalb der genannten Applikationsanlage aufgebracht. Demgemäß kann vorgesehen sein, dass die, insbesondere jede, Plasmabehandlung mit dem Plasmagenerator und/oder die, insbesondere jede, Aufbringung der Metallschicht und/oder die, insbesondere jede, Aufbringung der Schicht gebildet aus siliziumorganischen Verbindungen, insbesondere der Polysiloxanschicht, in der Vakuumaufdampfanlage oder in der Sputter-Anlage, vorgenommen wird. Dabei werden vorzugsweise die, insbesondere jede, Plasmabehandlung mit dem Plasmagenerator und die, insbesondere jede, Aufbringung der Metallschicht und die, insbesondere jede, Aufbringung der Schicht gebildet aus siliziumorganischen Verbindungen, insbesondere der Polysiloxanschicht, in der Vakuumaufdampfanlage oder in der Sputter-Anlage vorgenommen. Bevorzugt werden in einer Ausgestaltung des erfindungsgemäßen Verfahrens dabei die Aufbringung der Grundierungsschicht und/oder, vorzugsweise und, die Aufbringung der Deckschicht außerhalb der der Vakuumaufdampfanlage oder der Sputter-Anlage durchgeführt.

Für die Deckschicht kann z.B. auch auf wasserverdünnbare Beschichtungszusammensetzungen zurückgegriffen werden. Die Deckschicht kann gebildet werden aus Polyacrylatharzen, Polyesterharzen, Aminoplastharzen oder Polyurethanverbindungen. Bevorzugt werden bei den erfindungsgemäßen Verfahren solche Deckschichten aufgetragen, die auf ein UVhärtendes Beschichtungsmaterial zurückgehen. Demgemäß stellt eine bevorzugte Deckschicht eine UV-gehärtete Deckschicht dar. Die Deckschicht kann z.B. über einen Klarlack oder ein transparentes Pulver erhalten werden. Vorzugsweise wird die Deckschicht über ein Nasslackverfahren bzw. ein Pulverbeschichtungsverfahren aufgetragen. Bei der Deckschicht kann es sich demgemäß zum Beispiel um ein-, zwei- oder mehrkomponentige Lacke handeln, wobei Klarlacke bevorzugt sind. Bei diesen Klarlacken kann es sich z.B. um chemisch vernetzende zweikomponentige, um einkomponentige wärmehärtende oder um UV-härtende Lacke handeln. Des Weiteren kann für die Deckschicht auf 1K- oder 2K-Einbrennlack zurückgegriffen werden. Grundsätzlich können die für die Grundierungsschicht und die Deckschicht verwendeten Materialien in einer Ausführungsform auch im Wesentlichen übereinstimmen.

Des Weiteren wurde überraschend gefunden, dass in dem erfindungsgemäßen Verfahren der Schritt der Aufbringung der Deckschicht mittels elektrostatischer Lackierung aufgetragen werden kann. Dies führt zu einer nochmaligen Verringerung der Menge an benötigtem Beschichtungsmaterial für die Deckschicht. Auch kann so ein sehr gleichmäßiger Beschichtungsauftrag sichergestellt werden. Ferner gelingt auf diese Weise eine sogenannte Rundumlackierung wesentlich effektiver, d.h. es werden auch solche Areale beschichtet, die durch direkten Sprühauftrag nicht oder nur bedingt zugänglich sind. Das Verfahren der elektrostatischen Lackierung ist dem Fachmann bekannt. Mit dem erfindungsgemäßen Verfahren kann die aufgetragene Metallschicht, beispielsweise Aluminiumschicht, z.B. dazu genutzt werden, die erforderliche Spannung anzulegen. So kann in einer Ausführungsform beispielsweise eine positive Elektrode an das mit der Metallschicht beschichtete Substrat und eine negative Elektrode an eine Sprühvorrichtung angelegt werden. Auf diese Weise wird auch der Sprühstrahl entsprechend elektrisch aufgeladen.

Die Deckschicht verfügt in der Regel über eine Dicke im Bereich von 10 bis 50 µm, vorzugsweise im Bereich von 20 bis 30 µm. Erfindungswesentlich für die erfindungsgemäßen Verfahren ist, dass das die Deckschicht bildende Material auf eine zuvor mittels Plasmabehandlung und/oder Corona-Behandlung aktivierte Polysiloxanschicht, welche wiederum bevorzugt im Wege einer Plasmapolymerisation erhalten wurde, aufgetragen wird, und zwar vorzugsweise im Wesentlichen ohne zeitliche Verzögerung. Die Plasmabehandlung mit dem Plasmagenerator wird mitunter auch mit dem Begriff Glimmen beschrieben.

Für die Auftragung der Metallschichten kann zum Beispiel zurückgegriffen werden auf die Techniken der Physical Vapour Deposition (PVD), Chemical Vapour Deposition (CVD), des Aufdampfens mittels eines Elektronenstrahl-Verdampfers, des Aufdampfens mittels eines Widerstandsverdampfers, der Induktionsverdampfung, der ARC-Verdampfung oder der Kathoden- bzw. Anodenzerstäubung (Sputter-Beschichtung). Demgemäß kommen als Applikationsanlagen für die Aufbringung einer Metallschicht Vakuumaufdampfanlagen oder Sputter-Anlagen in Frage.

Geeignete Vakuumaufdampfanlagen umfassen zweckmäßigerweise PVD-Anlagen (Physical Vapour Deposition), CVD-Anlagen (Chemical Vapour Deposition), ElektronenstrahlVerdampfer, Widerstandsverdampfer, Induktionsverdampfer und ARC-Verdampfer. Geeignete Sputter-Anlagen umfassen zum Beispiel Kathodenzerstäuber und Anodenzerstäuber. Wie dem Fachmann bekannt ist, besteht eine Metallschicht vorwiegend aus Metall. Dies schließt Zusätze, wie sie beispielsweise bei rostfreiem Stahl in Form von Kohlenstoff zum Einsatz kommen, nicht gänzlich aus. Vorzugsweise ist der Metallanteil der vorliegenden Metallschicht größer 90 Gew%, insbesondere 95 Gew% und ganz besonders bevorzugt ≥ 98 Gew%.

Die Metallschicht ist eine aufgedampfte oder aufgesputterte Metallschicht, insbesondere ein PVD-Metallschicht. Beim PVD-Verfahren kommen im Allgemeinen widerstandsbeheizte Metallwendel- oder Metallschiffchenverdampfer zum Einsatz, wobei Wolframwendeln der verschiedensten Form bevorzugt sind. Beim PVD-Verfahren wird im Allgemeinen ein Verdampfer mit Wendeln bestückt, die auf voneinander isolierten Verdampferschienen geklemmt werden können. In jede Wendel wird vorzugsweise eine genau bestimmte Menge an aufzudampfendem Metall gegeben. Nach dem Schließen und Evakuieren der PVD-Anlage kann die Verdampfung durch Einschalten der Stromversorgung, wodurch man die Verdampferschienen die Wendel zum Glühen bringt, gestartet werden. Das feste Metall beginnt zu schmelzen und benetzt die meist verdrillten Wendeln vollständig. Durch weitere Energiezufuhr wird das flüssige Metall in die Gasphase überführt, so dass es sich auf dem zu beschichtenden Substrat abscheiden kann. Über die Menge an in die Gasphase überführtem Metall und/oder die Dauer der Beschichtungsphase kann die Dicke der Metallschicht, und damit auch das Erscheinungsbild derselben gezielt eingestellt werden.

Ein weiteres bevorzugtes Verfahren zur Abscheidung der Metallschicht auf dem Substrat ist die Kathodenzerstäubung (Sputter-Verfahren). Dabei wird in einem evakuierten Behälter eine Kathode angeordnet, die mit dem negativen Pol einer Stromversorgung verbunden ist. Das Beschichtungsmaterial, das zerstäubt wird, wird unmittelbar vor der Kathode montiert und die zu beschichtenden Substrate werden gegenüber dem zu zerstäubenden Beschichtungsmaterial angeordnet. Ferner kann Argon als Prozessgas durch den Behälter geleitet werden, der schließlich noch eine Anode aufweist, die mit dem positiven Pol einer Stromversorgung verbunden ist. Nachdem der Behälter vorevakuiert worden ist, werden Kathode und Anode mit der Stromversorgung verbunden. Durch den gezielten und gesteuerten Einlass von Argon wird die mittlere freie Weglänge der Ladungsträger deutlich gesenkt. Im elektrischen Feld zwischen Kathode und Anode werden Argonatome ionisiert. Die positiv geladenen Teilchen werden mit hoher Energie zur negativ geladenen Kathode beschleunigt. Beim Auftreffen und durch Teilchenstöße im Beschichtungsmaterial wird dieses in die Dampfphase überführt, mit hoher Energie in den freien Raum beschleunigt und kondensiert dann auf den zu beschichtenden Substraten. Mit dem Sputter-Verfahren lassen sich unterschiedliche Metallschichtdicken gezielt einstellen.

Die mit den genannten Verfahren und Anlagen erhältlichen Metallschichten verfügen vorzugsweise über eine durchschnittliche, insbesondere absolute, Dicke im Bereich von 1 nm bis 150 nm insbesondere im Bereich von 5 nm bis 120 nm. In einer sehr zweckmäßigen Ausgestaltung des erfindungsgemäßen beschichteten Substrats wird die Metallschicht zum Beispiel mit einer Dicke im Bereich von 60 nm bis 120 nm, vorzugsweise mit einer Dicke im Bereich von 75 nm bis 110 nm eingestellt. Bei diesen Dicken liegen die Metallschicht, insbesondere der Aluminiumschicht, deckend, d.h. im Wesentlichen nicht transparent oder transluzent auf der Oberfläche auf. Hierdurch können hochglänzende Schichten erhalten werden.

Gemäß einer ebenfalls besonders zweckmäßigen Ausgestaltung des erfindungsgemäßen Verfahrens wird die mit der mit der Applikationsanlage aufgebrachte Metallschicht, insbesondere Aluminiumschicht, in Schritt k) in einer Dicke aufgetragen, insbesondere aufgedampft oder aufgesputtert, dass diese Metallschicht, insbesondere auch nach Schritt l), m), n) und/oder o) oder nach Schritt m), n) und/oder o), unter Auslassung von Schritt l), für sichtbares Licht transparent oder transluzent ist. Alternativ kann vorgesehen sein, dass die mit der mit der Applikationsanlage aufgebrachte Metallschicht, insbesondere Aluminiumschicht, in Schritt k) in einer Dicke aufgetragen, insbesondere aufgedampft oder aufgesputtert, wird, dass diese Metallschicht für sichtbares Licht nicht transparent und nicht transluzent ist.

Eine Einfärbung der auf den nicht-metallischen und metallischen Substraten vorliegenden Beschichtung kann mit den erfindungsgemäßen Verfahren auch dadurch bewerkstelligt werden, dass für das Auftragen der Deckschicht ein Beschichtungsmaterial enthaltend mindestens ein Farbmittel, z.B. mindestens ein Pigment und/oder mindestens einen Farbstoff, eingesetzt wird. Auch lassen sich dem Fachmann bekannte Lasuren verwenden, um die Deckschicht einzufärben, beispielsweise um Messing-, Titan- und Goldtöne oder individuelle Farbtöne wie rot, blau, gelb, grün, etc. oder Eloxalfarbtöne zu erhalten. Zum Beispiel können in die Deckschicht auch Effektpigmente wie Perlglanzpigmente, LCP-Pigmente (liquid crystal polymer) oder OV-Pigmente (optical variable) eingearbeitet werden.

Die der Erfindung zu Grunde liegende Aufgabe wird des Weiteren gelöst durch ein beschichtetes metallisches oder nicht-metallisches Substrat, erhalten oder erhältlich nach dem vorangehend geschilderten erfindungsgemäßen Verfahren, umfassend, in dieser Reihenfolge, vorzugsweise unmittelbar aufeinanderfolgend,
A) ein, insbesondere gereinigtes, vorzugsweise entfettetes, metallisches oder nicht-metallisches Substrat,
E) mindestens eine, insbesondere eine, aus mindestens einer siliziumorganischen Verbindung mittels Plasmapolymerisation, gebildete Schicht, insbesondere Polysiloxanschicht,
G) eine, insbesondere eine, Grundierungsschicht,
   gegebenenfalls I) mindestens eine, insbesondere eine, aus mindestens einer siliziumorganischen Verbindung, insbesondere mittels Plasmapolymerisation, gebildete Schicht, insbesondere Polysiloxanschicht,
K) mindestens eine, insbesondere eine, mit einer Applikationsanlage mittels Aufdampf- und/oder Sputter-Technik, aufgebrachte Metallschicht,
M) mindestens eine, insbesondere eine, aus mindestens einer siliziumorganischen Verbindung mittels Plasmapolymerisation, gebildete Schicht, insbesondere Polysiloxanschicht,
O) mindestens eine, insbesondere eine, insbesondere transparente und/oder eingefärbte, Deckschicht.

Bei der vorangehend spezifizierten Ausgestaltung lösen solche erfindungsgemäßen beschichteten metallischen Substrate und solche erfindungsgemäßen beschichteten nicht-metallischen Substrate die der Erfindung zu Grunde liegende Aufgabe besonders gut, bei denen das zu beschichtende metallische oder nicht-metallische Substrat gemäß A) ein mit einem Plasma, insbesondere Argonplasma, im Vakuum behandeltes Substrat darstellt und/oder bei denen die aus mindestens einer siliziumorganischen Verbindung gebildete Schicht, insbesondere Polysiloxanschicht, gemäß E) eine mit einem Plasma, insbesondere Sauerstoffplasma, im Vakuum behandelte Schicht darstellt und/oder bei denen die Grundierungsschicht gemäß G) eine mit einem Plasma, insbesondere Argonplasma, im Vakuum behandelte Grundierungsschicht darstellt und/oder bei denen die aus mindestens einer siliziumorganischen Verbindung gebildete Schicht, insbesondere Polysiloxanschicht, gemäß M) eine mit einem Plasma, insbesondere Sauerstoffplasma, im Vakuum behandelte Schicht darstellt.

Offenbart ist auch ein nicht erfindungsgemäßes Verfahren zur Herstellung eines beschichteten Substrats, insbesondere eines beschichteten Keramik-, Glas- oder Stein-Substrats, umfassend
a) Zurverfügungstellung eines Substrats, insbesondere Keramik-, Glas- oder Stein-Substrats, mit mindestens einer zumindest bereichsweise beschichtbaren Oberfläche,
b) gegebenenfalls Zurverfügungstellung einer Applikationsanlage für die Aufbringung einer Metallschicht, insbesondere Vakuumaufdampfanlage oder Sputter-Anlage, und Zurverfügungstellung mindestens eines Plasmagenerators und/oder mindestens einer Corona-Anlage, insbesondere in der Applikationsanlage für die Aufbringung einer Metallschicht, wie Vakuumaufdampfanlage oder Sputter-Anlage, oder als Bestandteil hiervon,
c) gegebenenfalls Reinigen der mindestens einen zumindest bereichsweise beschichtbaren Oberfläche,
d) Beaufschlagen des Substrats oder der beschichtbaren Oberfläche des Substrats mit einem Vakuum (d1)) und Plasmabehandlung mit dem Plasmagenerator und/oder Corona-Behandlung, insbesondere Plasmabehandlung, des Substrats oder der beschichtbaren Oberfläche des Substrats, im Vakuum (d2)),
e) gegebenenfalls Behandeln des nach Schritt d) erhaltenen Substrats oder der beschichtbaren Oberfläche des Substrats mit mindestens einer siliziumorganischen Verbindung, insbesondere mittels Plasmapolymerisation, insbesondere unter Ausbildung einer Polysiloxanschicht,
f) gegebenenfalls Plasmabehandlung mit dem Plasmagenerator und/oder Corona-Behandlung, insbesondere Plasmabehandlung, der Schicht, insbesondere Polysiloxanschicht, gemäß Schritt e),
g) gegebenenfalls Aufbringen mindestens einer Grundierungsschicht auf das metallische Substrat oder das nicht-metallische Substrat, insbesondere Kunststoffsubstrat, oder die beschichtbare Oberfläche des metallischen Substrats oder des nicht-metallischen Substrats, insbesondere Kunststoffsubstrats, gemäß Schritt a), c) oder d) oder auf die Schicht, insbesondere Polysiloxanschicht, gemäß Schritt e) oder f),
h) gegebenenfalls Beaufschlagen des mit der Grundierungsschicht versehenen metallischen Substrats oder des mit der Grundierungsschicht versehenen nicht-metallischen Substrats, insbesondere Kunststoffsubstrats mit einem Vakuum (h1)) und/oder Plasmabehandlung mit dem Plasmagenerator und/oder Corona-Behandlung, insbesondere Plasmabehandlung, der Grundierungsschicht gemäß Schritt g) im Vakuum (h2)),
i) gegebenenfalls Behandeln der nach Schritt g) oder h), insbesondere h1) und h2), erhaltenen Grundierungsschicht mit mindestens einer siliziumorganischen Verbindung, insbesondere mittels Plasmapolymerisation, insbesondere unter Ausbildung einer Polysiloxanschicht, insbesondere im Vakuum,
j) gegebenenfalls Plasmabehandlung mit dem Plasmagenerator und/oder Corona-Behandlung, insbesondere Plasmabehandlung, der Schicht, insbesondere Polysiloxanschicht, gemäß Schritt i), insbesondere im Vakuum,
k) gegebenenfalls Aufbringen mindestens einer Metallschicht, enthaltend oder bestehend aus einem Metall ausgewählt aus der Gruppe bestehend aus Aluminium, Silber, Gold, Blei, Vanadium, Mangan, Magnesium, Eisen, Kobalt, Nickel, Kupfer, Chrom, Palladium, Molybdän, Wolfram, Platin, Titan, Zirkonium und Zink, insbesondere Aluminium, oder enthaltend oder bestehend aus einer Metalllegierung ausgewählt aus der Gruppe bestehend aus Messing, Bronze, Stahl, insbesondere Edelstahl, Aluminium-, Magnesium- und Titanlegierungen, mit der Applikationsanlage, insbesondere mittels Aufdampf- und/oder Sputter-Technik, insbesondere unmittelbar, auf eine nach Schritt d2), mit vorausgegangenem Schritt d1), Schritt ) oder Schritt j) erhaltene Schicht,
l) gegebenenfalls Plasmabehandlung mit dem Plasmagenerator und/oder Corona-Behandlung, insbesondere Plasmabehandlung, der Metallschicht gemäß Schritt k),
m) Behandeln der nach Schritt d2), g), h), k) oder l) erhaltenen Schicht mit mindestens einer siliziumorganischen Verbindung, insbesondere mittels Plasmapolymerisation, insbesondere unter Ausbildung einer Polysiloxanschicht, insbesondere im Vakuum,
n) Plasmabehandlung mit dem Plasmagenerator und/oder Corona-Behandlung, insbesondere Plasmabehandlung, der Schicht, insbesondere Polysiloxanschicht, gemäß Schritt m), insbesondere im Vakuum, und
o) Auftragen mindestens einer, insbesondere transparenten und/oder eingefärbten, Deckschicht auf die behandelte Schicht, insbesondere Polysiloxanschicht, gemäß Schritt n).

Bei den vorangehend spezifizierten Ausgestaltungen erfindungsgemäßer Verfahren lösen auch solche die zugrunde liegende Aufgabe besonders gut, bei denen die Schritte d1), d2), m), n) und o), insbesondere unter Auslassung der Schritte d), e) bis l), oder die Schritte d1), d2), k), m), n) und o), insbesondere unter Auslassung der Schritte e) bis j) und l) jeweils, insbesondere unmittelbar, aufeinander folgen.

Offenbart wird auch ein nicht erfindungsgemäßes, beschichtetes Substrat, insbesondere erhalten oder erhältlich nach dem vorangehend geschilderten Verfahren, umfassend, insbesondere in dieser Reihenfolge, vorzugsweise unmittelbar aufeinanderfolgend,
A) ein, insbesondere gereinigtes, vorzugsweise entfettetes, im Vakuum plasmabehandeltes und/oder coronabehandeltes, insbesondere plasmabehandeltes, Substrat, insbesondere Keramik-, Glas- oder Steinsubtrat,
M) mindestens eine, insbesondere eine, aus mindestens einer siliziumorganischen Verbindung, insbesondere mittels Plasmapolymerisation, gebildete und im Vakuum plasmabehandelte und/oder coronabehandelte, insbesondere plasmabehandelte, Schicht, insbesondere Polysiloxanschicht,
O) mindestens eine, insbesondere eine, insbesondere transparente und/oder eingefärbte, Deckschicht; oder
A) ein, insbesondere gereinigtes, vorzugsweise entfettetes, im Vakuum plasmabehandeltes und/oder coronabehandeltes, insbesondere plasmabehandeltes, Substrat, insbesondere Verbundfasermaterial-, Carbonmaterialien- und/oder Kunststoffsubstrat,
K) mindestens eine, insbesondere eine, mit einer Applikationsanlage, insbesondere mittels Aufdampf- und/oder Sputter-Technik, aufgebrachte Metallschicht,
M) mindestens eine, insbesondere eine, aus mindestens einer siliziumorganischen Verbindung, insbesondere mittels Plasmapolymerisation, gebildete und im Vakuum plasmabehandelte und/oder coronabehandelte, insbesondere plasmabehandelte, Schicht, insbesondere Polysiloxanschicht,
O) mindestens eine, insbesondere eine, insbesondere transparente und/oder eingefärbte, Deckschicht.

Für die Durchführung des erfindungsgemäßen Verfahrens kann auch auf eine Applikationsanlage für die Aufbringung einer Metallschicht zurückgegriffen werden, umfassend oder darstellend eine Vakuumaufdampfanlage mit einer Vakuumkammer, und mindestens eine, insbesondere eine Vielzahl an ersten beheizbaren Aufnahmeeinheiten, insbesondere Schalen, Schiffchen oder Wendeln, jeweils in Wirkverbindung mit einer Heizeinrichtung oder eine Heizeinrichtung umfassend oder darstellend, jeweils ausgelegt und geeignet für die Aufnahme eines Metalls oder einer Metalllegierung, und ferner eine Steuereinrichtung für die Einstellung der Schmelz- bzw. Verdampfungstemperatur.

Dabei kann in einer Ausführungsvariante vorgesehen sein, dass die Applikationsanlage für die Aufbringung einer Metallschicht mindestens ein, insbesondere außerhalb der Vakuumkammer der Vakuumaufdampfanlage vorliegendes Behältnis zur Aufnahme einer siliziumorganischen Verbindung mit einer Zuführleitung zur Vakuumkammer umfasst.

Als besonders zweckdienlich hat es sich erwiesen, die Applikationsanlage für die Aufbringung der Metallschicht ebenfalls auszustatten mit mindestens einem, insbesondere in der Vakuumkammer vorliegenden, Gestell mit einer Längsorientierung und mit mindestens einem Träger, insbesondere in Form einer Welle, der im Wesentlichen entlang der Längsorientierung des Gestells ausgerichtet ist, ausgelegt und eingerichtet zur Aufnahme mindestens eines, insbesondere einer Vielzahl an nicht-metallischen und/oder metallischen Substraten, wobei das Gestell und/oder der mindestens eine Träger um eine, insbesondere im Wesentlichen horizontal ausgerichtete, Achse rotiert wahr sind. Geeignete Gestelle, die mit der Applikationsanlage verwendet werden können, sind zum Beispiel der EP 2 412 445 und der DE 20 2007 016 072 zu entnehmen.

Die erfindungsgemäßen beschichteten Substrate bzw. die nach den erfindungsgemäßen Verfahren erhältlichen beschichteten Substrate bestehen regelmäßig den Dampfstrahltest, z.B. nach DIN EN ISO 16925:2014-06, den Kondenswasser-Konstantklima-Test, z.B. nach DIN EN ISO 6270-2, den Hydrolysetest, z.B. nach BMW-Norm AA-0203 oder AA-P 308, den Salzsprühnebeltest, z.B. nach DIN EN ISO 9227 und/oder die Gitterschnittprüfung, z.B. nach DIN EN ISO 2-409:2013-06. Bevorzugt können sogar sämtliche bzw. nahezu sämtliche der genannten Tests bestanden werden.

Die erfindungsgemäßen beschichteten Substrate, die nach dem erfindungsgemäßen Verfahren erhalten worden sind oder erhältlich sind werden eingesetzt als Zubehörteil für den Automobilbau, Motorradbau, Fahrradbau oder Schiffbau, für Felgen, insbesondere Leichtmetallfelgen, Räder, insbesondere Leichtmetallräder oder als Bestandteil hiervon, für Sanitäreinrichtungsgegenstände, insbesondere als Armatur, oder als Bestandteil hiervon, für Karosserieinnen- oder Außenbauteile oder als Bestandteil hiervon, für Griffe oder Griffkomponenten, insbesondere Türgriffe oder als Bestandteil hiervon, für Profile oder Rahmen, insbesondere Fensterrahmen oder als Bestandteil hiervon, für Beschlagsysteme oder als Bestandteil hiervon, insbesondere Schilder und Türschilder, für Gehäuse oder als Verpackung oder als Bestandteil hiervon, für Innen- oder Außenbauteile von Schiffen oder als Bestandteil hiervon, für Schmuckgegenstände oder als Bestandteil hiervon, für Edelbauteile oder als Bestandteil hiervon, für Innen- oder Außenmöbel oder für Bestandteile hiervon, für Haushaltsgeräte, insbesondere Kaffeemaschinen, oder Bestandteile hiervon, für Innen- oder Außenbauteile von Flugzeugen oder als Bestandteil hiervon, für Innen- oder Außenbauteile von Gebäuden oder als Bestandteil hiervon, für Heizkörper oder Rohre oder als Bestandteil hiervon, für Bauteile von Aufzügen oder als Bestandteil hiervon, für Bauteile von Elektronikkomponenten oder -Geräten oder als Bestandteil hiervon, für Bauteile von Küchengeräten, beispielsweise Kaffeemaschinen, oder als Bauteil von Kommunikationskomponenten oder -Geräten, insbesondere Handys, oder als Bestandteil hiervon.

Der Erfindung liegt die überraschende Erkenntnis zugrunde, dass mit den nach den erfindungsgemäßen Verfahren erhältlichen Substraten eine hochwertige Glanzbeschichtung zur Verfügung gestellt wird, die dauerhaft ihren Glanz behält. Außerdem wurde überraschend gefunden, dass die nach dem erfindungsgemäßen Verfahren erhältlichen beschichteten nicht-metallischen und metallischen Substrate mit einer hervorragenden Korrosionsbeständigkeit ausgestattet sind. Die nach den erfindungsgemäßen Verfahren erhältlichen beschichteten Substrate zeichnen sich zudem durch eine ausgeprägte Haftung aus. Demgemäß zeigen diese beschichteten Substrate selbst dann überragende Korrosionsbeständigkeiten, wenn die Oberflächen mechanische Beschädigungen erfahren haben, beispielsweise mittels Steinschlag oder durch Anritzen. Ein weiterer Vorteil, der mit den erfindungsgemäßen Verfahren sowie mit der erfindungsgemäßen Applikationsanlage einhergeht, ist, dass nur noch sehr geringe Umrüstzeiten erforderlich sind, um neue Substratschargen zu beschichten. Darüber hinaus ermöglicht das erfindungsgemäße Verfahren, den Umfang der Gesamtanlage zur Herstellung beschichteter Substrate ausgehend von dem noch nicht gereinigten, zu beschichtenden Substrat erheblich zu verringern, so dass ein signifikant reduzierter Platzbedarf gegenüber herkömmlichen Anlagen besteht. Darüber hinaus gelingt es mit den erfindungsgemäßen Verfahren, die Bearbeitungszeit bis zur Fertigstellung des beschichteten verkaufsfertigen Substrats erheblich zu verringern. Hiermit gehen zwangsläufig verringerte Zykluszeiten einher.

Von ganz besonderem, überraschenden Vorteil ist auch, dass die mit dem erfindungsgemäßen Verfahren hergestellten beschichteten Substrate weder Kantenaufbau noch Kantenflucht zeigen, und gleichzeitig auch in der Massenfertigung einen signifikant verringerten Anteil an Ausschussware mit sich bringen. Es gelingt auf zuverlässige und reproduzierbare Weise, selbst hochwertige Chromoberflächen identisch nachzustellen, ohne dass hierbei Chrom oder andere Schwermetalle zum Einsatz kommen. Schließlich stellen sich obige Vorteile überraschenderweise selbst bei Verringerung der Vorbehandlungs- bzw. Reinigungsschritte und/oder bei Verringerung des Vorbehandlungs- bzw. Reinigungsaufwands ein.

Die in der vorstehenden Beschreibung und in den Ansprüchen offenbarten Merkmale der Erfindung können sowohl einzeln aus auch in jeder beliebigen Kombination für die Verwirklichung der Erfindung in ihren verschiedenen Ausführungsformen wesentlich sein. Der Gegenstand der Erfindung wird durch die Ansprüche definiert.

## Patentansprüche

1. Verfahren zur Herstellung eines beschichteten metallischen Substrats oder eines beschichteten nicht-metallischen Substrats, insbesondere Kunststoffsubstrats, umfassend
a) Zurverfügungstellung eines metallischen Substrats oder eines nicht-metallischen Substrats, insbesondere Kunststoffsubstrats, mit mindestens einer zumindest bereichsweise beschichtbaren Oberfläche,
b) Zurverfügungstellung einer Applikationsanlage für die Aufbringung einer Metallschicht, insbesondere Vakuumaufdampfanlage oder Sputter-Anlage, und Zurverfügungstellung mindestens eines Plasmagenerators und/oder mindestens einer Corona-Anlage, insbesondere in der Applikationsanlage für die Aufbringung einer Metallschicht, wie Vakuumaufdampfanlage oder Sputter-Anlage, oder als Bestandteil hiervon,
c) gegebenenfalls Reinigen der mindestens einen zumindest bereichsweise beschichtbaren Oberfläche,
d) Beaufschlagen des metallischen Substrats oder des nicht-metallischen Substrats, insbesondere Kunststoffsubstrats, oder der beschichtbaren Oberfläche des metallischen Substrats oder des nicht-metallischen Substrats, insbesondere Kunststoffsubstrats, mit einem Vakuum (d1)) und Plasmabehandlung mit dem Plasmagenerator des metallischen Substrats oder des nicht-metallischen Substrats, insbesondere Kunststoffsubstrats, oder der beschichtbaren Oberfläche des nicht-metallischen Substrats, insbesondere Kunststoffsubstrats, oder des metallischen Substrats, im Vakuum (d2)),
e) Behandeln des nach Schritt d) erhaltenen metallischen Substrats oder nicht-metallischen Substrats, insbesondere Kunststoffsubstrats, oder der beschichtbaren Oberfläche des metallischen Substrats oder des nicht-metallischen Substrats, insbesondere Kunststoffsubstrats, mit mindestens einer siliziumorganischen Verbindung mittels Plasmapolymerisation, insbesondere unter Ausbildung einer Polysiloxanschicht,
f) gegebenenfalls Plasmabehandlung, vorzugsweise im Vakuum, mit dem Plasmagenerator und/oder Corona-Behandlung, insbesondere Plasmabehandlung, der Schicht, insbesondere Polysiloxanschicht, gemäß Schritt e),
g) Aufbringen mindestens einer Grundierungsschicht auf das metallische Substrat oder das nicht-metallische Substrat, insbesondere Kunststoffsubstrat, oder die beschichtbare Oberfläche des metallischen Substrats oder des nicht-metallischen Substrats, insbesondere Kunststoffsubstrats, gemäß Schritt e) oder f),
h) Beaufschlagen des mit der Grundierungsschicht versehenen metallischen Substrats oder des mit der Grundierungsschicht versehenen nicht-metallischen Substrats, insbesondere Kunststoffsubstrats mit einem Vakuum (h1)) und Plasmabehandlung mit dem Plasmagenerator der Grundierungsschicht gemäß Schritt g) im Vakuum (h2)),
i) gegebenenfalls Behandeln der nach Schritt g) oder h), insbesondere h1) und h2), erhaltenen Grundierungsschicht mit mindestens einer siliziumorganischen Verbindung, insbesondere mittels Plasmapolymerisation, insbesondere unter Ausbildung einer Polysiloxanschicht, insbesondere im Vakuum,
j) gegebenenfalls Plasmabehandlung, vorzugsweise im Vakuum, mit dem Plasmagenerator und/oder Corona-Behandlung, insbesondere Plasmabehandlung, der Schicht, insbesondere Polysiloxanschicht, gemäß Schritt i), insbesondere im Vakuum,
k) Aufbringen mindestens einer Metallschicht, enthaltend oder bestehend aus einem Metall ausgewählt aus der Gruppe bestehend aus Aluminium, Silber, Gold, Blei, Vanadium, Mangan, Magnesium, Eisen, Kobalt, Nickel, Kupfer, Chrom, Palladium, Molybdän, Wolfram, Platin, Titan, Zirkonium und Zink, insbesondere Aluminium, oder enthaltend oder bestehend aus einer Metalllegierung ausgewählt aus der Gruppe bestehend aus Messing, Bronze, Stahl, insbesondere Edelstahl, Aluminium-, Magnesium- und Titanlegierungen, mit der Applikationsanlage mittels Aufdampf- und/oder Sputter-Technik unmittelbar auf die behandelte Grundierungsschicht gemäß Schritt h2), oder i) oder j),
l) gegebenenfalls Plasmabehandlung, vorzugsweise im Vakuum, mit dem Plasmagenerator und/oder Corona-Behandlung, insbesondere Plasmabehandlung, der Metallschicht gemäß Schritt k),
m) Behandeln der nach Schritt k) oder l) erhaltenen Metallschicht mit mindestens einer siliziumorganischen Verbindung mittels Plasmapolymerisation, insbesondere unter Ausbildung einer Polysiloxanschicht im Vakuum,
n) Plasmabehandlung mit dem Plasmagenerator der Schicht, insbesondere Polysiloxanschichtgemäß Schritt m) im Vakuum und
o) Auftragen mindestens einer, insbesondere transparenten und/oder eingefärbten, Deckschicht auf die behandelte Schicht, insbesondere Polysiloxanschicht, gemäß Schritt n).

2. Verfahren nach Anspruch 1, **dadurch gekennzeichnet, dass** die Schritte g), h1) und h2), k), m), n) und o), oder die Schritte d1) und d2), k), m), n) und o), oder die Schritte g), h), j), k), l), m), n) und o), oder die Schritte d1) und d2), g) h1) und h2), k), m), n) und o), oder die Schritte d1) und d2), k), m), n) und o), oder die Schritte d1) und d2), e), f), g), h1)und h2), k), m), n) und o), insbesondere unter Auslassung der Schritte i) und j), jeweils, insbesondere unmittelbar, aufeinander folgen.

3. Verfahren nach Anspruch 1 oder 2, **dadurch gekennzeichnet, dass** das Metallsubstrat Metalle oder Metalllegierungen umfasst oder hieraus besteht oder dass das nicht-metallische Substrat Glas, Keramik, Steinmaterialien, Verbundfasermaterialien, Carbonmaterialien, Kunststoff oder Holz, insbesondere Verbundfasermaterialien, Carbonmaterialien und/oder Kunststoff, umfasst oder hieraus besteht.

4. Verfahren nach einem oder mehreren der vorangehenden Ansprüche, **dadurch gekennzeichnet, dass** die siliziumorganische Verbindung mindestens ein aminohaltiges Silan, insbesondere Amino-propyltriethoxysilan, Hexamethyldisiloxan, Tetramethyldisiloxan oder deren beliebige Mischungen umfasst, insbesondere Hexamethyldisiloxan.

5. Verfahren nach einem oder mehreren der vorangehenden Ansprüche, **dadurch gekennzeichnet, dass**
der Schritt der Plasmabehandlung mit dem Plasmagenerator unter Einsatz von mindestens einem Inertgas, insbesondere Argon, oder
unter Einsatz von mindestens einem Inertgas, insbesondere Argon, und Sauerstoff Stickstoff, Kohlendioxid, Wasserstoff, Kohlenmonoxid, Wasserstoffperoxidgas Wasserdampf, Ozon und/oder Luft, insbesondere Sauerstoff, oder
unter Einsatz von Sauerstoff, Stickstoff, Wasserstoff, Kohlendioxid, Kohlenmonoxid Wasserstoffperoxidgas, Wasserdampf, Ozon und/oder Luft, insbesondere Sauerstoff, vorzugsweise unter Ausschluss von Inertgasen,
durchgeführt wird.

6. Verfahren nach einem oder mehreren der vorangehenden Ansprüche, **dadurch kennzeichnet, dass**
die, insbesondere jede, Plasmabehandlung mit dem Plasmagenerator und/oder die insbesondere jede, Aufbringung der Metallschicht und/oder die, insbesondere Aufbringung der durch Plasmabehandlung von siliziumorganischen Verbindungen erhaltenen Schicht, insbesondere Polysiloxanschicht, in der Vakuumdampfanlage oder in der Sputter-Anlage, vorgenommen wird.

7. Verfahren nach einem oder mehreren der vorangehenden Ansprüche, **dadurch kennzeichnet, dass**
die Deckschicht und/oder die Grundierungsschicht Polyacrylatharze, Polyesterharze, Aminoplastharze oder Polyurethanverbindungen umfasst oder hieraus besteht und/oder
dass die Deckschicht und/oder die Grundierungsschicht aus einem UV-härtenden Beschichtungsmaterial oder aus einem 1K- oder 2K-Einbrennlack gebildet ist besondere eine UV-gehärtete Deckschicht oder eine 1K- oder 2K-Einbrennlack Deckschicht darstellt und/oder dass
die Grundierungsschicht und/oder die Deckschicht, insbesondere die Deckschicht mittels elektrostatischer Lackierung aufgetragen wird.

8. Verfahren nach einem oder mehreren der vorangehenden Ansprüche, **dadurch kennzeichnet, dass**
die Metallschicht mittels Physical Vapour Deposition (PVD), Chemical Vapour position (CVD), Aufdampfen mittels eines Elektronenstrahl-Verdampfers, Aufdampfen mittels eines Widerstandsverdampfers, Induktionsverdampfung, ARC-Verdampfung oder Kathoden- bzw. Anodenzerstäubung (Sputter-Beschichtung) aufgebracht wird.

9. Verfahren nach einem oder mehreren der vorangehenden Ansprüche, **dadurch gekennzeichnet, dass**
die Plasmabehandlung mit dem Plasmagenerator und/oder das Behandeln mit mindestens einer siliziumorganischen Verbindung mittels Plasmapolymerisation, insbesondere unter Ausbildung einer Polysiloxanschicht, und/oder das Aufbringen der mindestens einen Metallschicht mit der Applikationsanlage unter Vakuum vorgenommen werden.

10. Verfahren nach einem oder mehreren der vorangehenden Ansprüche, **dadurch gekennzeichnet, dass**
die Plasmabehandlung gemäß Schritt d2) und/oder f), insbesondere d2), unter Einsatz von Argon und/oder dass die Plasmabehandlung gemäß Schritt h2) und/oder j), insbesondere j), unter Einsatz von Sauerstoff durchgeführt wird.

11. Beschichtetes metallisches oder nicht-metallisches Substrat, erhalten oder erhältlich nach einem Verfahren gemäß einem oder mehreren der Ansprüche 1 bis 10, umfassend in dieser Reihenfolge, vorzugsweise unmittelbar aufeinanderfolgend,
A) ein, insbesondere gereinigtes, vorzugsweise entfettetes, metallisches oder nicht-metallisches Substrat,
E) mindestens eine, insbesondere eine, aus mindestens einer siliziumorganischen Verbindung mittels Plasmapolymerisation gebildete Schicht, insbesondere Polysiloxanschicht,
G) mindestens eine, insbesondere eine, Grundierungsschicht,
gegebenenfalls I) mindestens eine, insbesondere eine, aus mindestens einer siliziumorganischen Verbindung, insbesondere mittels Plasmapolymerisation, gebildete Schicht, insbesondere Polysiloxanschicht,
K) mindestens eine, insbesondere eine, mit einer Applikationsanlage mittels Aufdampf- und/oder Sputter-Technik aufgebrachte Metallschicht,
M) mindestens eine, insbesondere eine, aus mindestens einer siliziumorganischen Verbindung mittels Plasmapolymerisation gebildete Schicht, insbesondere Polysiloxanschicht,
O) mindestens eine, insbesondere eine, insbesondere transparente und/oder eingefärbte, Deckschicht.

12. Verwendung des beschichteten metallischen oder nicht-metallisches Substrats gemäß Anspruch 11 als Zubehörteil für den Automobilbau, Motorradbau, Fahrradbau oder Schiffbau, für Felgen, insbesondere Leichtmetallfelgen, Räder, insbesondere Leichtmetallräder oder als Bestandteil hiervon, für Sanitäreinrichtungsgegenstände, insbesondere als Armatur, oder als Bestandteil hiervon, für Karosserieinnen- oder Außenbauteile oder als Bestandteil hiervon, für Griffe oder Griffkomponenten, insbesondere Türgriffe oder als Bestandteil hiervon, für Profile oder Rahmen, insbesondere Fensterrahmen oder als Bestandteil hiervon, für Beschlagsysteme oder als Bestandteil hiervon, insbesondere Schilder und Türschilder, für Gehäuse oder als Verpackung oder als Bestandteil hiervon, für Innen- oder Außenbauteile von Schiffen oder als Bestandteil hiervon, für Haushaltsgeräte, insbesondere Kaffeemaschinen, oder Bestandteile hiervon, für Schmuckgegenstände oder als Bestandteil hiervon, für Edelbauteile oder als Bestandteil hiervon, für Innen- oder Außenmöbel oder für Bestandteile hiervon, für Innen- oder Außenbauteile von Flugzeugen oder als Bestandteil hiervon, für Innen- oder Außenbauteile von Gebäuden oder als Bestandteil hiervon, für Heizkörper oder Rohre oder als Bestandteil hiervon, für Bauteile von Aufzügen oder als Bestandteil hiervon, für Bauteile von Elektronikkomponenten oder -Geräten oder als Bestandteil hiervon, für Bauteile von Küchengeräten, beispielsweise Kaffeemaschinen, oder als Bauteil von Kommunikationskomponenten oder -Geräten, insbesondere Handys, oder als Bestandteil hiervon.

## Claims

1. A method for producing a coated metallic substrate or a coated non-metallic substrate, in particular a plastic substrate, comprising
a) providing a metallic substrate or non-metallic substrate, in particular plastic substrate, with at least one surface that can be coated at least in certain areas,
b) providing an application system for the application of a metal layer, in particular a vacuum vapor deposition system or sputter system, and providing at least one plasma generator and/or at least one corona system, in particular in the application system for the application of a metal layer, such as a vacuum vapor deposition system or sputter system, or as part thereof,
c) optionally cleaning the at least one surface that can be coated at least in certain areas,
d) subjecting the metallic substrate or non-metallic substrate, in particular plastic substrate, or the surface of the metallic substrate or the non-metallic substrate, in particular plastic substrate, that can be coated, to a vacuum (d1)) and plasma treatment of the metallic substrate or non-metallic substrate, in particular plastic substrate, or the surface of the non-metallic substrate, in particular plastic substrate, or metallic substrate, that can be coated, in a vacuum (d2)) with the plasma generator,
e) treating the metallic substrate or non-metallic substrate, in particular plastic substrate, obtained after step d), or the surface of the metallic substrate or non-metallic substrate, in particular plastic substrate, that can be coated, with at least one organosilicon compound by means of plasma polymerization, in particular with the formation of a polysiloxane layer,
f) optionally plasma treatment, preferably in a vacuum, with the plasma generator and/or corona treatment, in particular plasma treatment, of the layer, in particular polysiloxane layer, according to step e),
g) applying at least one primer layer to the metallic substrate or non-metallic substrate, in particular plastic substrate, or to the surface of the metallic substrate or non-metallic substrate, in particular plastic substrate, that can be coated, according to step e) or f),
h) subjecting the metallic substrate provided with the primer layer or the non-metallic substrate, in particular plastic substrate, provided with the primer layer, to a vacuum (h1)) and plasma treatment of the primer layer according to step g) in a vacuum (h2)) with the plasma generator,
i) optionally treating the primer layer obtained after step g) or h), in particular h1) and h2), with at least one organosilicon compound, in particular by means of plasma polymerization, in particular with the formation of a polysiloxane layer, in particular in a vacuum,
j) optionally plasma treatment, preferably in a vacuum, with the plasma generator and/or corona treatment, in particular plasma treatment, of the layer, in particular polysiloxane layer, according to step i), in particular in a vacuum,
k) applying at least one metal layer containing or consisting of a metal selected from the group consisting of aluminum, silver, gold, lead, vanadium, manganese, magnesium, iron, cobalt, nickel, copper, chromium, palladium, molybdenum, tungsten, platinum, titanium, zirconium and zinc, in particular aluminum, or containing or consisting of a metal alloy selected from the group consisting of brass, bronze, steel, in particular stainless steel, aluminum, magnesium and titanium alloys, with the application system, by means of vapor deposition and/or sputtering technology, directly on the treated primer layer according to step h2), or i) or j),
l) optionally plasma treatment, preferably in a vacuum, with the plasma generator and/or corona treatment, in particular plasma treatment, of the metal layer according to step k),
m) treating the metal layer obtained after step k) or 1) with at least one organosilicon compound by means of plasma polymerization, in particular with the formation of a polysiloxane layer, in a vacuum,
n) plasma treatment of the layer, in particular polysiloxane layer according to step m), in a vacuum, with the plasma generator, and
o) applying at least one, in particular transparent and/or colored, top layer to the treated layer, in particular polysiloxane layer, according to step n).

2. The method according to claim 1, **characterized in that** steps g), h1) and h2), k), m), n) and o), or steps d1) and d2), k), m), n) and o), or steps g), h), j), k), 1), m), n) and o), or steps d1) and d2), g), h1) and h2), k), m), n) and o), or steps d1) and d2), k), m), n) and o), or steps d1) and d2), e), f), g), h1) and h2), k), m), n) and o), in particular omitting steps i) and j), in each case, are consecutive, in particular immediately consecutive.

3. The method according to claim 1 or 2, **characterized in that** the metal substrate comprises or consists of metals or metal alloys or **in that** the non-metallic substrate comprises or consists of glass, ceramic, stone materials, composite fiber materials, carbon materials, plastic or wood, in particular composite fiber materials, carbon materials and/or plastic.

4. The method according to any one or more of the preceding claims, **characterized in that**
the organosilicon compound comprises at least one amino-containing silane, in particular aminopropyltriethoxysilane, hexamethyldisiloxane, tetramethyldisiloxane or any mixtures thereof, in particular hexamethyldisiloxane.

5. The method according to any one or more of the preceding claims, **characterized in that**
the step of plasma treatment is carried out with the plasma generator using at least one inert gas, in particular argon, or using at least one inert gas, in particular argon, and oxygen, nitrogen, carbon dioxide, hydrogen, carbon monoxide, hydrogen peroxide gas, water vapor, ozone and/or air, in particular oxygen, or using oxygen, nitrogen, hydrogen, carbon dioxide, carbon monoxide, hydrogen peroxide gas, water vapor, ozone and/or air, in particular oxygen, preferably with the exclusion of inert gases.

6. The method according to any one or more of the preceding claims, **characterized in that**
the, in particular each, plasma treatment with the plasma generator and/or the, in particular each, application of the metal layer and/or the, in particular each, application of the layer obtained by plasma treatment of organosilicon compounds, in particular polysiloxane layer, is made in the vacuum vapor deposition system or in the sputter system.

7. The method according to any one or more of the preceding claims, **characterized in that**
the top layer and/or the primer layer comprise(s) or consist(s) of polyacrylate resins, polyester resins, aminoplast resins or polyurethane compounds and/or
**in that** the top layer and/or the primer layer is formed from a UV-curing coating material or a 1K - or 2K stoving varnish, in particular represents a UV-cured top layer or a 1K or 2K stoving varnish top layer and/or
**in that** the primer layer and/or the top layer, in particular the top layer, is applied by means of electrostatic painting.

8. The method according to any one or more of the preceding claims, **characterized in that**
the metal layer is applied by means of Physical Vapor Deposition (PVD), Chemical Vapor Deposition (CVD), vapor deposition by means of an electron beam vaporizer, vapor deposition by means of a resistance vaporizer, induction vaporization, ARC vaporization or cathode or anode atomization (sputter coating).

9. The method according to any one or more of the preceding claims, **characterized in that**
the plasma treatment with the plasma generator and/or the treatment with at least one organosilicon compound by means of plasma polymerization, in particular with the formation of a polysiloxane layer, and/or the application of the at least one metal layer with the application system are made under vacuum.

10. The method according to any one or more of the preceding claims, **characterized in that**
the plasma treatment according to step d2) and/or f), in particular d2) is carried out using argon and/or **in that** the plasma treatment according to step h2) and/or j), in particular j), is carried out using oxygen.

11. A coated metallic or non-metallic substrate, obtained or obtainable by a method according to any one or more of claims 1 to 10, comprising, in this order, preferably immediately consecutive,
A) a, in particular cleaned, preferably degreased, metallic or non-metallic substrate,
E) at least one, in particular one, layer formed from at least one organosilicon compound by means of plasma polymerization, in particular a polysiloxane layer,
G) at least one, in particular one, primer layer,
optionally I) at least one, in particular one, layer formed from at least one organosilicon compound, in particular by means of plasma polymerization, in particular a polysiloxane layer,
K) at least one, in particular one, metal layer applied with an application system by means of vapor deposition and/or sputtering technology,
M) at least one, in particular one, layer formed from at least one organosilicon compound by means of plasma polymerization, in particular a polysiloxane layer,
O) at least one, in particular one, in particular transparent and/or colored top layer.

12. Use of the coated metallic or non-metallic substrate according to claim 11 as an accessory for automobile manufacture, motorcycle manufacture, bicycle manufacture or shipbuilding, for rims, in particular light metal rims, wheels, in particular light metal wheels or as a component thereof, for sanitary fixtures, in particular as fittings, or as a component thereof, for interior or exterior body parts or as a component thereof, for handles or handle components, in particular door handles or as a component thereof, for profiles or frames, in particular window frames or as a component thereof, for fitting systems or as a component thereof, in particular signs and door plates, for housings or as packaging or as a component thereof, for interior or exterior parts of ships or as a component thereof, for household appliances, in particular coffee machines, or components thereof, for jewelry or as a component thereof, for precious parts or as a component thereof, for interior or exterior furniture or for components thereof, for interior or exterior parts of aircraft or as a component thereof, for interior or exterior parts of buildings or as a component thereof, for radiators or pipes or as a component thereof, for parts of elevators or as a component thereof, for parts of electronic components or devices or as a component thereof, for parts of kitchen appliances, for example coffee machines, or as a part of communication components or devices, in particular cell phones, or as a component thereof.

## Revendications

1. Procédé pour fabriquer un substrat métallique revêtu ou un substrat non métallique revêtu, en particulier substrat plastique, comprenant
a) la mise à disposition d'un substrat métallique ou d'un substrat non métallique, en particulier substrat plastique, avec au moins une surface pouvant être revêtue au moins par endroits,
b) la mise à disposition d'une installation d'application pour le dépôt d'une couche métallique, en particulier installation de vaporisation sous vide ou installation de pulvérisation cathodique,
et la mise à disposition d'au moins un générateur de plasma et/ou d'au moins une installation à effet couronne, en particulier dans l'installation d'application pour le dépôt d'une couche métallique, telle qu'une installation de vaporisation sous vide ou installation de pulvérisation cathodique, ou en tant qu'élément de celle-ci,
c) le cas échéant le nettoyage de la au moins une surface pouvant être revêtue au moins par endroits,
d) la sollicitation du substrat métallique ou du substrat non métallique, en particulier substrat plastique, ou de la surface pouvant être revêtue du substrat métallique ou du substrat non métallique, en particulier substrat plastique, avec un vide (d1)) et traitement par plasma avec le générateur de plasma du substrat métallique ou du substrat non métallique, en particulier substrat plastique, ou de la surface pouvant être revêtue du substrat non métallique, en particulier substrat plastique, ou du substrat métallique, dans le vide (d2)),
e) le traitement du substrat métallique ou substrat non métallique, en particulier substrat plastique, obtenu après l'étape d), ou de la surface pouvant être revêtue du substrat métallique ou du substrat non métallique, en particulier substrat plastique, avec au moins un composé organosilicié au moyen d'une polymérisation par plasma, en particulier avec formation d'une couche de polysiloxane,
f) le cas échéant traitement par plasma, de préférence sous vide, avec le générateur de plasma et/ou traitement à effet couronne, en particulier traitement par plasma, de la couche, en particulier couche de polysiloxane, selon l'étape e),
g) l'application d'au moins une couche d'apprêt sur le substrat métallique ou le substrat non métallique, en particulier substrat plastique, ou la surface pouvant être revêtue du substrat métallique ou du substrat non métallique, en particulier substrat plastique, selon l'étape e) ou f),
h) la sollicitation du substrat métallique pourvu de la couche d'apprêt ou du substrat non métallique pourvu de la couche d'apprêt, en particulier substrat plastique avec un vide (h1)) et traitement par plasma avec le générateur de plasma de la couche d'apprêt selon l'étape g) sous vide (h2)),
i) le cas échéant le traitement de la couche d'apprêt obtenue après l'étape g) ou h), en particulier h1) et h2), avec au moins un composé organosilicié, en particulier au moyen d'une polymérisation par plasma, en particulier avec formation d'une couche de polysiloxane, en particulier sous vide,
j) le cas échéant le traitement par plasma, de préférence sous vide, avec le générateur de plasma et/ou traitement à effet couronne, en particulier traitement par plasma, de la couche, en particulier couche de polysiloxane, selon l'étape i), en particulier sous vide,
k) le dépôt d'au moins une couche métallique, contenant ou constituée d'un métal sélectionné dans le groupe constitué par l'aluminium, l'argent, l'or, le plomb, le vanadium, le manganèse, le magnésium, le fer, le cobalt, le nickel, le cuivre, le chrome, le palladium, le molybdène, le tungstène, le platine, le titane, le zirconium et le zinc, en particulier l'aluminium, ou contenant ou constitué d'un alliage métallique sélectionné dans le groupe constitué par le laiton, le bronze, l'acier, en particulier l'acier inoxydable, les alliages d'aluminium, de magnésium et de titane, avec l'installation d'application au moyen d'une technique de vaporisation sous vide et/ou de pulvérisation cathodique directement sur la couche d'apprêt traitée selon l'étape h2), ou i) ou j),
l) le cas échéant le traitement par plasma, de préférence sous vide, avec le générateur de plasma et/ou traitement à effet couronne, en particulier traitement par plasma, de la couche métallique selon l'étape k),
m) le traitement de la couche métallique obtenue après l'étape k) ou 1) avec au moins un composé organosilicié au moyen d'une polymérisation par plasma, en particulier avec formation d'une couche de polysiloxane sous vide,
n) le traitement par plasma avec le générateur de plasma de la couche, en particulier couche de polysiloxane selon l'étape m) sous vide et
o) le dépôt d'au moins une couche de recouvrement, en particulier transparente et/ou encrée, sur la couche traitée, en particulier couche de polysiloxane, selon l'étape n).

2. Procédé selon la revendication 1, **caractérisé en ce que** les étapes g), h1) et h2), k), m), n) et o) ou les étapes d1) et d2), k), m), n) et o), ou les étapes g), h), j), k), 1), m), n) et o) ou les étapes d1) et d2), g), h1) et h2), k), m), n) et o), ou les étapes d1) et d2), k), m), n) et o) ou les étapes d1) et d2), e), f), g), h1) et h2), k), m), n) et o), en particulier avec omission des étapes i) et j), respectivement, se succèdent, en particulier immédiatement.

3. Procédé selon la revendication 1 ou 2, **caractérisé en ce que** le substrat métallique comprend des métaux ou alliages métalliques ou en est constitué ou que le substrat non métallique comprend du verre, de la céramique, des matériaux en pierre, des matériaux fibreux composites, des matériaux en carbone, du plastique ou du bois, en particulier des matériaux fibreux composites, des matériaux en carbone et/ou du plastique, ou en est constitué.

4. Procédé selon l'une ou plusieurs des revendications précédentes, **caractérisé en ce que**
le composé organosilicié comprend au moins un silane aminé, en particulier amino-propyltriéthoxysilane, hexaméthyldisiloxane, tétraméthyldisiloxane ou leurs mélanges quelconques, en particulier hexaméthyldisiloxane.

5. Procédé selon l'une ou plusieurs des revendications précédentes, **caractérisé en ce que**
l'étape du traitement par plasma est effectuée avec le générateur de plasma au moyen d'au moins un gaz inerte, en particulier d'argon, ou au moyen d'au moins un gaz inerte, en particulier d'argon, et d'oxygène, d'azote, de dioxyde de carbone, d'hydrogène, de monoxyde de carbone, de gaz peroxyde d'hydrogène, de vapeur d'eau, d'ozone et/ou d'air, en particulier d'oxygène, ou au moyen d'oxygène, d'azote, d'hydrogène, de dioxyde de carbone, de monoxyde de carbone, de gaz peroxyde d'hydrogène, de vapeur d'eau, d'ozone et/ou d'air, en particulier d'oxygène, de préférence avec exclusion de gaz inertes.

6. Procédé selon l'une ou plusieurs des revendications précédentes, **caractérisé en ce que**
le, en particulier chaque, traitement par plasma avec le générateur de plasma et/ou la, en particulier chaque, dépôt de la couche métallique et/ou la, en particulier chaque, dépôt de la couche, en particulier couche de polysiloxane, obtenue par traitement par plasma de composés organosiliciés, est réalisé dans l'installation d'évaporation sous vide ou dans l'installation de pulvérisation cathodique.

7. Procédé selon l'une ou plusieurs des revendications précédentes, **caractérisé en ce que**
la couche de recouvrement et/ou la couche d'apprêt comprend de la résine polyacrylate, de la résine polyester, de la résine aminoplaste ou des composés polyuréthane ou en est constituée et/ou
que la couche de recouvrement et/ou la couche d'apprêt est formée d'un matériau de revêtement durcissant aux UV ou d'une peinture au four 1K ou 2K, en particulier une couche de recouvrement durcie aux UV ou une couche de recouvrement de peinture au four 1K ou 2K et/ou que
la couche d'apprêt et/ou la couche de recouvrement, en particulier la couche de recouvrement, est appliquée au moyen d'une mise en peinture électrostatique.

8. Procédé selon l'une ou plusieurs des revendications précédentes, **caractérisé en ce que**
la couche métallique est appliquée au moyen d'un dépôt physique en phase vapeur (PVD), dépôt chimique en phase vapeur (CVD), évaporation au moyen d'un évaporateur à bombardement électronique, évaporation au moyen d'un évaporateur à résistance, évaporation à induction, évaporation par arc électrique ou pulvérisation cathodique ou anodique (revêtement par pulvérisation cathodique).

9. Procédé selon l'une ou plusieurs des revendications précédentes, **caractérisé en ce que**
le traitement par plasma avec le générateur de plasma et/ou le traitement avec au moins un composé organosilicié au moyen d'une polymérisation par plasma, en particulier avec formation d'une couche de polysiloxane, et/ou le dépôt de la au moins une couche métallique avec l'installation d'application sont réalisés sous vide.

10. Procédé selon l'une ou plusieurs des revendications précédentes, **caractérisé en ce que**
le traitement par plasma est effectué selon l'étape d2) et/ou f), en particulier d2), au moyen d'argon et/ou que le traitement par plasma est effectué selon l'étape h2) et/ou j), en particulier j), au moyen d'oxygène.

11. Substrat métallique ou non métallique revêtu, obtenu ou pouvant être obtenu selon un procédé selon l'une ou plusieurs des revendications 1 à 10, comprenant dans cet ordre, de préférence de manière immédiatement successive,
A) un substrat métallique ou non métallique, en particulier nettoyé, de préférence dégraissé,
E) au moins une, en particulier une, couche formée d'au moins un composé organosilicié au moyen d'une polymérisation par plasma, en particulier couche de polysiloxane,
G) au moins une, en particulier une, couche d'apprêt,
le cas échéant I) au moins une, en particulier une, couche, en particulier couche de polysiloxane, formée d'au moins un composé organosilicié, en particulier au moyen d'une polymérisation par plasma,
K) au moins une, en particulier une, couche métallique déposée avec une installation d'application au moyen d'une technique d'évaporation et/ou de pulvérisation cathodique,
M) au moins une, en particulier une, couche, en particulier couche de polysiloxane, formée d'au moins un composé organosilicié au moyen d'une polymérisation par plasma,
O) au moins une, en particulier une, couche de recouvrement en particulier transparente et/ou encrée.

12. Utilisation du substrat métallique ou non métallique revêtu selon la revendication 11 comme accessoire pour la construction d'automobiles, construction de motocyclettes, construction de bicyclettes ou construction navale, pour des jantes, en particulier des jantes en métal léger, des roues, en particulier des roues en métal léger ou en tant qu'élément de celles-ci, pour des objets d'appareils sanitaires, en particulier en tant que robinetterie, ou en tant qu'élément de ceux-ci, pour des pièces intérieures ou extérieures de carrosserie ou en tant qu'élément de celles-ci, pour des poignées ou composants de poignée, en particulier poignées de portes ou en tant qu'élément de celles-ci, pour des profilés ou cadres, en particulier cadres de fenêtres ou en tant qu'élément de ceux-ci, pour des systèmes de ferrure ou en tant qu'élément de ceux-ci, en particulier des plaques et plaques de portes, pour des boîtiers ou en tant qu'emballage ou en tant qu'élément de ceux-ci, pour des pièces intérieures ou extérieures de navires ou en tant qu'élément de celles-ci, pour des appareils ménagers, en particulier des machines à café, ou des élément de ceux-ci, pour des objets décoratifs ou en tant qu'élément de ceux-ci, pour des pièces précieuses ou en tant qu'élément de celles-ci, pour des meubles d'intérieur ou d'extérieur ou pour des éléments de ceux-ci, pour des pièces intérieures ou extérieures d'avions ou en tant qu'élément de celles-ci, pour des pièces intérieures ou extérieures de bâtiments ou en tant qu'élément de celles-ci, pour des corps de chauffe ou tubes ou en tant qu'élément de ceux-ci, pour des pièces d'ascenseurs ou en tant qu'élément de celles-ci, pour des pièces de composants ou appareils électroniques ou en tant qu'élément de celles-ci, pour des pièces d'appareils de cuisine, par exemple de machines à café, ou en tant que pièce de composants ou appareils de communication, en particulier téléphones portables, ou en tant qu'élément de celles-ci.
